Europäisches Patentamt

(19) European Patent Office

Office européen des brevets

(11) EP 0 883 179 A2

(12) EUROPEAN PATENT APPLICATION

(43) Date of publication:
09.12.1998 Bulletin 1998/50

(51) Int. Cl.6: H01L 23/467, H01L 23/367

(21) Application number: 98109814.8

(22) Date of filing: 29.05.1998

(84) Designated Contracting States:
AT BE CH CY DE DK ES FI FR GB GR IE IT LI LU
MC NL PT SE
Designated Extension States:
AL LT LV MK RO SI

(30) Priority: 04.06.1997 US 869080

(71) Applicant: LSI LOGIC CORPORATION
Milpitas, CA 95035 (US)

(72) Inventor:
The designation of the inventor has not yet been
filed

(74) Representative:
Gleiss, Alf-Olav, Dr.jur. Dipl.-Ing. et al
Gleiss & Grosse
Patentanwaltskanzlei
Maybachstrasse 6A
70469 Stuttgart (DE)

(54) Spiral pin-fin heatsink for electronic packages

(57) A heat sink (1) for use within a semiconductor package includes a base member (2) having an upper surface (5) and a lower surface (3), the lower surface being attachable to a surface of a semiconductor package. A plurality of heat dissipating pin-fins (4) are attached to the base member (2). More particularly, each pin-fin (4) includes a central pin (12) having a bonding point (20) that attaches to the upper surface (5) of the base member. Each pin-fin (4) further has at least one fin (13 or 14). The fins associated with each pin-fin may be configured in various shapes and patterns.

FIG. 14

FIG. 3A

EP 0 883 179 A2

## Description

### TECHNICAL FIELD

This invention relates generally to semiconductor packaging technology, and more particularly, to providing heat sinks useful with semiconductor packages. Still more particularly, the invention relates to providing heat sinks useful with semiconductor packages having improved heat dissipating pin-fins.

### BACKGROUND OF THE INVENTION

The amount of heat generated by a semiconductor device, or chip, is related to the number of transistors on the device and the clock speeds at which they are operated. As more and more transistors are fabricated onto a single semiconductor device, the overall amount of heat generated by the device is increased. Similarly, the faster the transistors on the chip are operated, the more heat is generated by the device. Since advances in semiconductor fabrication technology continue to make possible both increased transistor density and higher clock speeds, the problem of heat generation is becoming increasingly severe, particularly in high performance devices which push the limits of fabrication technology.

As an increasing amount of heat is generated by the device, the junction temperatures of the transistors in the device increases proportionately. The failure rate of a semiconductor device is directly related to the junction temperature at which it is operated. The higher the junction temperature, the higher the failure rate.

It is generally known to provide a heat spreader or heat sink for a semiconductor device in order to transfer the generated heat away from the device itself and into the surrounding air, thus reducing the junction temperature. Heat sinks generally are located as physically close to the semiconductor device as possible in order to maximize the amount of heat transferred. Heat sinks typically are constructed from a high thermal conductivity material, such as copper, aluminum or high thermal conductivity plastic, and are designed to present a maximum amount of surface area to the ambient air in order to allow the heat generated by the semiconductor device to be removed, either by natural or forced convection.

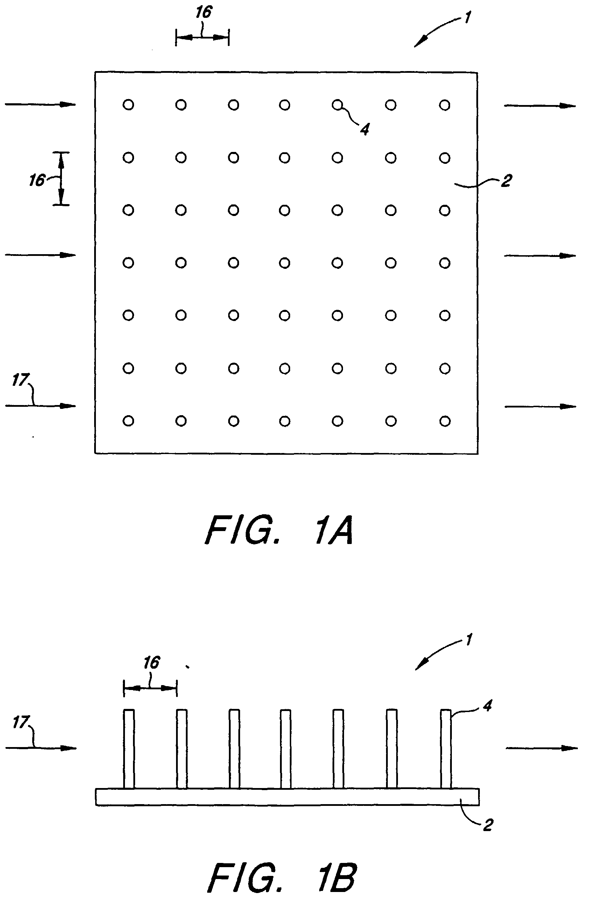

One way that heat sinks increase the amount of surface area available for heat dissipation is to provide a plurality cooling pin-fins which rise vertically from a horizontal surface, or base member. One conventional heat sink is shown in Figures 1A, 1B and 1C. In this example, the heat sink 1 includes a base member 2, having a base surface 3 which is attachable to a corresponding surface of the semiconductor package. Heat sink 1 is also provided with a heat dissipating surface 5. In this case, the surface 5 includes pin-fins 4a, 4b, ... 4n which provide greater surface area for convection cooling. Forced convection may be provided by a fan which passes air over a circuit board to which the packaged semiconductor is mounted, or, in some cases, a fan may be mounted directly onto the top of the heat sink pin-fins themselves.

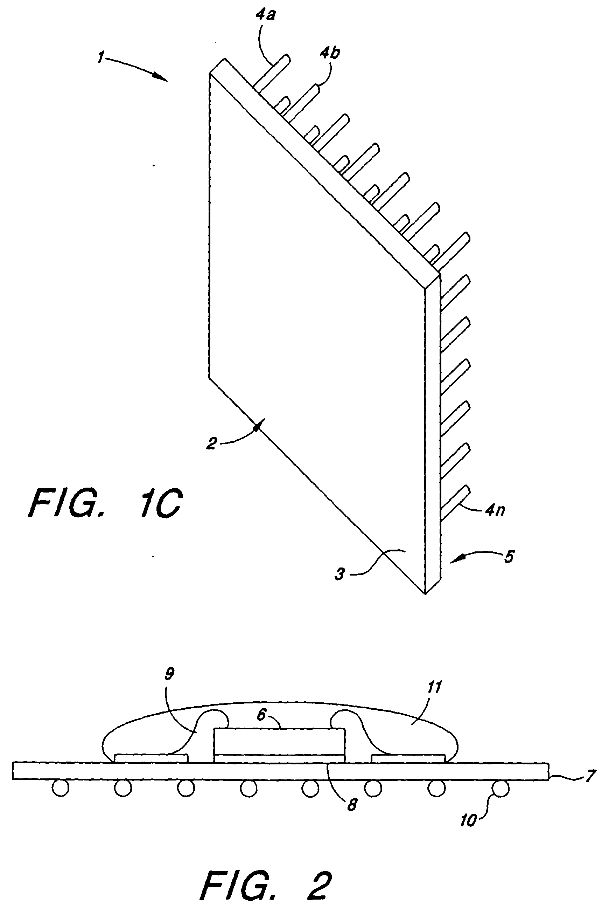

Regardless of the exact type of heat sink employed, modem semiconductor packaging technologies present numerous challenges to provide heat sinks, and methods for attaching heat sinks, in commercially practical applications. For example, one common type of package is the encapsulated package, shown in cross-section in Figure 2. The particular encapsulated package shown is referred to as a ball grid array ("BGA"). In this case, the semiconductor die 6 is attached to a substrate 7 by a suitable adhesive, or die attach material 8. Substrate 7 is typically of laminar construction and various electrically conductive paths are formed on individual layers. Electrical connection between the individual layers is provided by vias in the substrate. Electrical connection between the I/O bond pads on the die 6 and conductive paths provided on the substrate 7 is provided by bond wires 9. The conductive paths on substrate 7 are coupled to electrically conductive members, i.e., solder balls 10 which provide electrical connection to a printed circuit board ("PCB"). In order to protect the delicate bond wires 9, the chip is encapsulated with, for example, epoxy 11 to form what is sometimes referred to as a "glob-top." Similar encapsulated packages include, for example, pin grid array packages ("PGA") which provide cylindrical pins in place of the solder balls 10 shown in the figure.

Typically, the substrate 7 is constructed from either a ceramic material, in which case the package is referred to as a ceramic ball grid array ("CBGA"), or a plastic material, in which case the package is referred to as a plastic ball grid array ("PBGA"). While the ceramic substrates offer certain advantages over plastic substrates with respect to heat conductivity, mechanical strength and moisture resistance, plastic substrates are being increasingly used because of lower manufacturing costs and their ability to provide thinner overall packages. Moreover, advances in manufacturing have improved the plastic substrates relative to their ceramic counterparts. For example, improvements in sealing the laminar layers of the plastic substrates have made them almost as moisture resistant as ceramic substrates.

When a heat sink, such as that shown in Figures 1A, 1B and 1C, relies on providing additional surface area for heat dissipation, the power dissipation capability increases proportionally with the surface area of the heat sink. The heat dissipation due to the convective heat transfer mechanism is, generally, the dominate heat transfer mode for electronic packages. A somewhat simplified equation for determining the heat dissipation in an electronic package having a heat sink such as that shown in Figures 1A, 1B and 1C, is the following:

$$Q = (hA)(T_s - T_a)$$

where Q is the total heat dissipated from the heat sink, in watts (W), h is the convective heat transfer coefficient ($W/m^2C°$), A is the total surface area of the heat sink, and $T_s$ and $T_a$ are the heat sink surface temperature and the ambient temperature, respectively. Assuming that the heat transfer coefficient and the temperatures are constant, the amount of heat dissipation is increased by increasing the heat sink surface area. Accordingly, for high performance electronic packages, heat sinks with a larger surface area are required to dissipate the heat generated by the semiconductor device. However, the increase in area also results in a larger heat sink size and greater heat sink weight.

Accordingly, it is an object of this invention to provide a heat sink having an improved thermal dissipation capacity which overcomes the above mentioned problems. Further objects and advantages of the present invention will become apparent in view of the following disclosure.

## SUMMARY OF THE INVENTION

One aspect of the invention relates to a semiconductor package having an attached heat sink. According to one embodiment of the invention, a semiconductor package comprises: a semiconductor die mounted to an upper surface of a package substrate, the semiconductor die having a plurality of bond pads which are electrically coupled to conductive traces formed on the package substrate; a plurality of conductive members attached to a lower surface of the package substrate and coupled to conductive traces formed on the package substrate, wherein the conductive members are connectable to conductive traces formed on a printed circuit board to provide electrical connection between the bond pads on the semiconductor die and the conductive traces formed on the printed circuit board; a heat sink comprising: a base member having an upper surface and a lower surface, the lower surface being attachable to a surface of a semiconductor package; and a plurality of heat dissipating pin-fins, wherein each pin-fin of the plurality comprises a bonding point and a distal end, wherein each pin-fin of the plurality is coupled to the upper surface of the base member at the bonding point, wherein each pin-fin of the plurality of heat dissipating pin-fins comprises at least one fin.

Another aspect of the invention relates to a heat sink useful in semiconductor packages. According to one embodiment of the invention, a heat sink comprises: a base member having an upper surface and a lower surface, the lower surface being attachable to a surface of a semiconductor package; and a plurality of heat dissipating pin-fins, wherein each pin-fin of the plurality comprises a bonding point and a distal end, wherein each pin-fin of the plurality is coupled to the upper surface of the base member at the bonding point, wherein each pin-fin of the plurality of heat dissipating pin-fins comprises at least one fin.

## BRIEF DESCRIPTION OF THE DRAWINGS

Figure 1A is a top view of a conventional pin-fin heat sink.

Figure 1B is a side view of the conventional pin-fin heat sink shown in Figure 1A.

Figure 1C is a perspective view of the conventional pin-fin heat sink shown in Figures 1A and 1B.

Figure 2 is a cross-sectional side view of a ball grid array ("BGA") semiconductor package.

Figure 3A is a side view of a single pin-fin of the present invention with a spiral fin.

Figure 3B is a top view of the pin-fin shown in Figure 3A.

Figure 4 is a side view of a single pin-fin of the present invention with a plurality of disc fins.

Figure 5 is a top view of an embodiment of the single pin-fin shown in figure 4, this embodiment having circular disc fins.

Figure 6 is a top view of an embodiment of the single pin-fin shown in figure 4, this embodiment having square disc fins.

Figure 7 is a side view of a pin-fin with a plurality of disc fins which are warped.

Figure 8 is a side view of a pin-fin with a plurality of disc fins which are corrugated.

Figure 9 is a side view of a pin-fin with a plurality of disc fins which are corrugated and placed in an offset fashion.

Figure 10A is a top view of a heat sink embodiment of the present invention having pin-fins arranged in in-line fashion.

Figure 10B is a side view of the heat sink embodiment of the present invention having pin-fins shown in Figure 10A.

Figure 11 is a perspective view of a heat sink of the present invention having pin- fins attached thereto with spiral fins.

Figure 12A is a top view of a heat sink embodiment of the present invention having pin-fins arranged in staggered fashion.

Figure 12B is a side view of the heat sink embodiment of the present invention having pin-fins shown in Figure 12A.

Figure 13A is a top view of a ducted heat sink embodiment of the present invention.

Figure 13B is a side view of the ducted heat sink embodiment shown in Figure 13A.

Figure 13C is a perspective view of a ducted heat sink embodiment similar to that shown in Figures 13A and 13B, except the pin-fins have spiral fins.

Figure 14 is a cross-sectional side view of a heat sink of the present invention attached to a semiconductor package.

Figure 15 is a cross-sectional side view of a heat sink of the present invention having a recess, attached to a semiconductor package.

Figure 16 is a perspective view of a heat sink of the present invention having a recess.

Figure 17 is a side view of a heat sink of the present invention having disc fins on adjacent pin-fins which are offset to enable closer placement of the pin-fins to each other.

## DETAILED DESCRIPTION OF EMBODIMENTS OF THE INVENTION

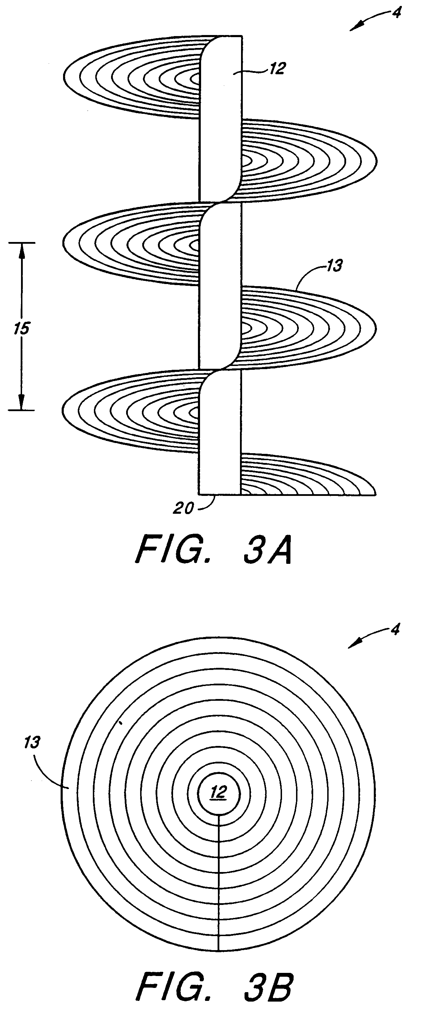

Referring to Figures 3A and 3B, side and top views of an embodiment of a single pin-fin of the present invention are shown. The pin-fin 4 comprises a central pin 12 which supports a spiral fin 13. The central pin 12 has a bonding point 20 for attaching the central pin to a base member of a heat sink. The spiral fin 13 is attached to the central pin 12 beginning at the bottom of the central pin 12, circling around the central pin 12 in an upward spiral fashion until it reaches the top of the central pin 12. The size of the spiral fin 13 is defined by the radius of the spiral and the pitch 15 of the spiral fin 13. The pitch 15 is a measurement of the distance between two consecutive windings of the spiral fin 13 in a direction parallel to the central pin 12. The smaller the pitch, the more windings of the spiral fin 13 and hence more surface area for heat dissipation. Alternatively, a larger pitch provides a greater slope to the spiral fin 13 which induces turbulence in the air flow. Thus, depending on the particular application, an optimum pitch is that which provides the greatest heat dissipation by having a perfect balance between the surface area and the turbulence of the air flow.

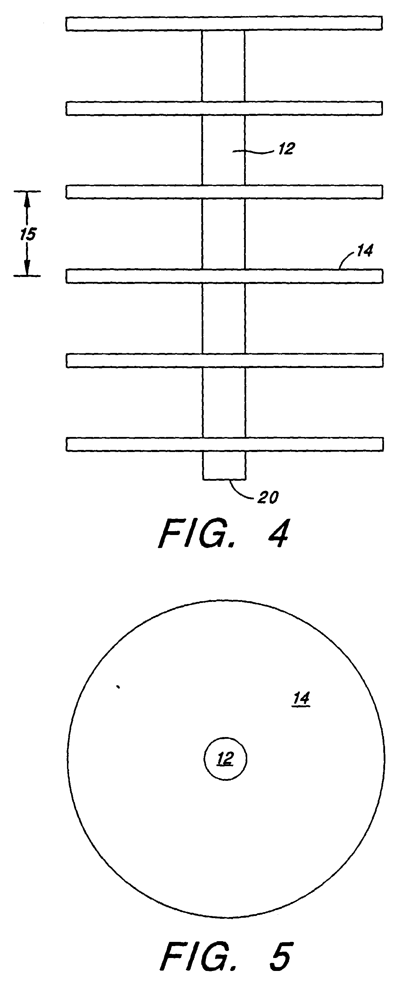

Referring to Figure 4, a side view of an alternative embodiment of the pin-fin is shown. Here the central pin 12 has a bonding point 20 for attaching the central pin 12 to a base member of a heat sink and several disc fins 14 attached thereto. In this particular embodiment, the disc, fins 14 are planar and perpendicular to the central pin 12. The pitch 15 is a measure of the distance between two adjacent disc fins 14. Of course, the more disc fins 14 attached to the central pin 12, the greater the surface area of the particular pin-fin 4 and the smaller the pitch 15.

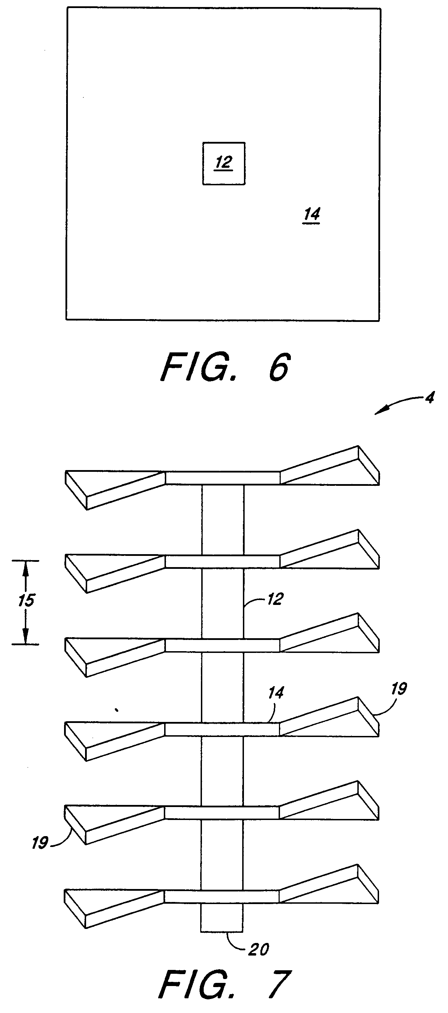

Alternative embodiments have disc fins 14 of various shapes. For example, referring to Figure 5, a top view of an alternative embodiment of the pin-fin shown in Figure 4 is depicted. In this embodiment, the central pin 12 and disc fins 14 are circular. The circular disc fins are more advantageous where it is desirable to have densely packed pin-fins on a heat sink. Further, with reference to Figure 6, a top view of an embodiment of the pin-fin shown in Figure 4 is shown. In this embodiment, both the central pin 12 and the disc fins 14 are rectangularly shaped. The square corners of the central pin 12 induce turbulence in the fluid which flows around the pin-fin. Further the square disc fins 14 provide additional surface area depending on the proximity and placement of adjacent pin-fins. Another center pin 12 has a corrugated, dimpled or bumpy surface to further induce turbulence at the surface of the center pin 12. The disc fins 14 and spiral fins 13 also may have a dimpled or bumpy surface to further induce turbulence at the surface of the fins.

Alternative embodiments of both the spiral and disc pin-fins have fins which are warped or angled, rather than planar. For example, Figure 7 is a side view of a pin-fin having square disc fins 14 attached to a central pin 12. The square disc fins 14 have warped corners 19 which are turned up and down. The warped corners 19 induce turbulence around the pin-fin 4.

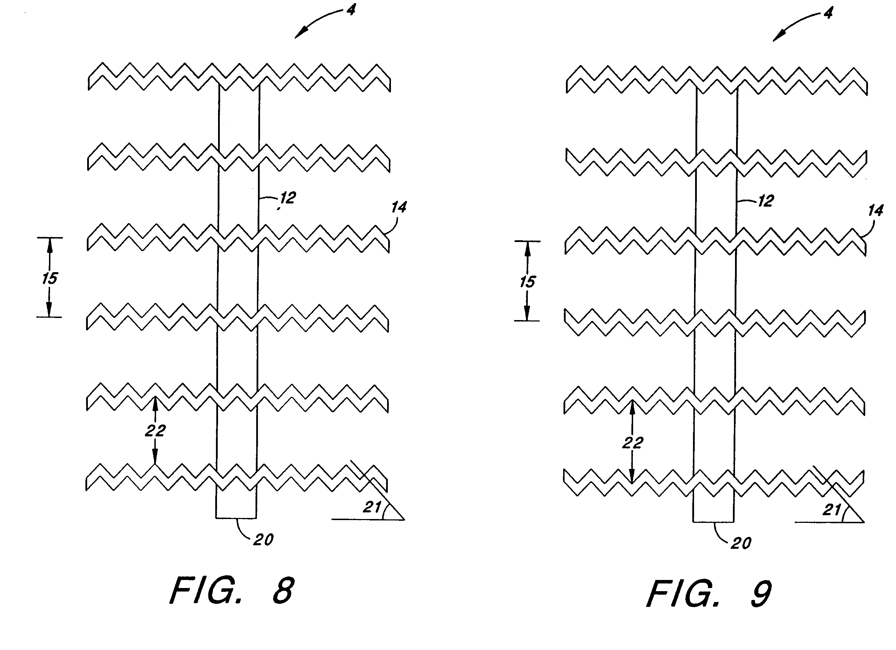

Further, alternative embodiments comprise spiral and disc fins which are corrugated. A side view of one embodiment with corrugated disc fins 14 is shown in Figure 8. While the corrugation shown has a "V" shaped cross-section, other cross- sections are also possible such as a "square block" shape and a sinusoidal shape. It is preferred to attach the disc fins 14 to the center pin 12 so that the corrugation lines are transverse to the direction of heat exchanging fluid flow over the pin-fin. This allows the corrugated disc fins 14 to induce turbulence in the fluid. Further, where the heat exchanging fluid passes over the pin-fin 4 from different directions, it is preferred to attach the different disc fins 14 to the central pin 12 with the corrugation lines running in different directions. This ensures that the corrugation lines of at least one disc fin are transverse to the direction of fluid flow.

The increased turbulence caused by the corrugations results in increased impingement and mixing of the particles that make up the fluid which flows around the pin-fins 4 of the heat sink 1. The increased impingement and mixing effectively results in an increase in the heat transfer coefficient. As will be understood from the heat transfer equation described previously, an increased heat transfer coefficient results in greater heat transfer Q for a particular heat sink.

The amount of increased turbulence in the fluid flow can be controlled by adjusting the corrugation angle 21 shown in Figure 8. The greater the corrugation angle 21, the greater the amount of turbulence in the fluid flow. Any suitable corrugation angle can be chosen, from 0, i.e., a planar fin, to 90°. In one particular embodiment, the invention comprises a plurality of corrugated disc fins having a corrugation angle a of between about 5° and about 90°.

The amount of turbulence in the fluid flow through the space between adjacent disc fins 14 of the same pin-fin 4 may also be controlled by offsetting the undulations in one disc fin 14 with those in adjacent disc fin 14. For example, as shown by reference line 22 in Figure 8, the undulations in adjacent disc fins correspond to other. In other words, when an undulation increases in one direction in one disc fin, the corresponding undulation in the adjacent disc fin also increases in the same direction. Thus, the distance between the walls of the disc fins is always constant. By contrast, as shown at reference line 22 in Figure 9, adjacent disc fins are disposed such that when an undulation increases in one direction in one disc fin, the corresponding undulation the adjacent disc fin decreases in the same direction. Thus, the distance between the walls of the disc fins changes along their lengths. In still further embodiments, turbulence of the fluid flow can be increased by providing different corrugation angles to different disc fins attached to the same central pin.

In all of these embodiments, the pitch 15 is an important factor in determining the surface area of the pin-fin. Because heat is transferred to the pin-fin at the bonding point 20 of the central pin 12 from the base member 2 of the heat sink 1, it is desirable to have as much pin-fin surface area near the base member of the heat sink. Therefore, in an embodiment of the pin-fin 4, the pitch 15 of the pin-fin 4 increases from the bonding point 20 toward the distal end of the pin-fin. Alternatively, an embodiment comprises a pin-fin wherein the pitch decreases from the bonding point 20 toward the distal end of the pin-fin.

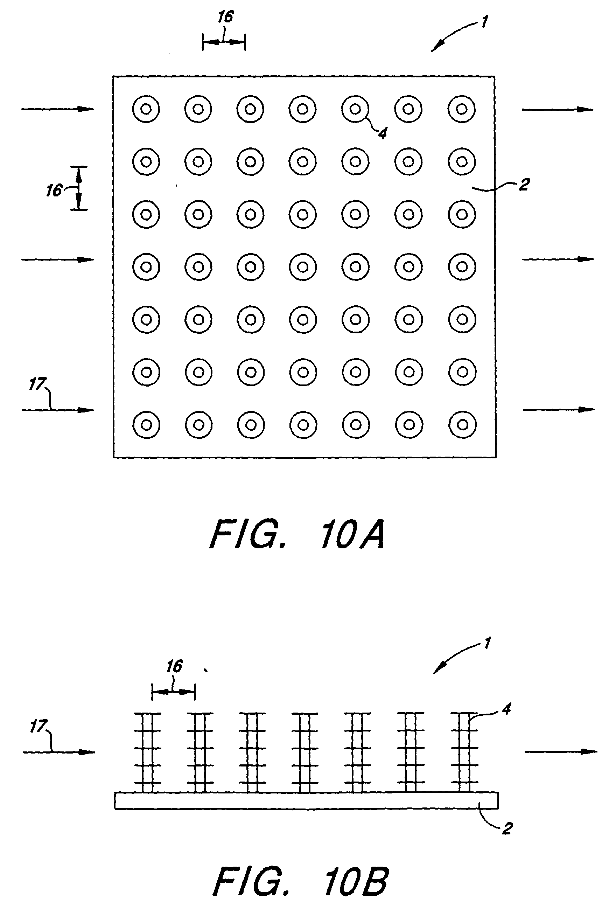

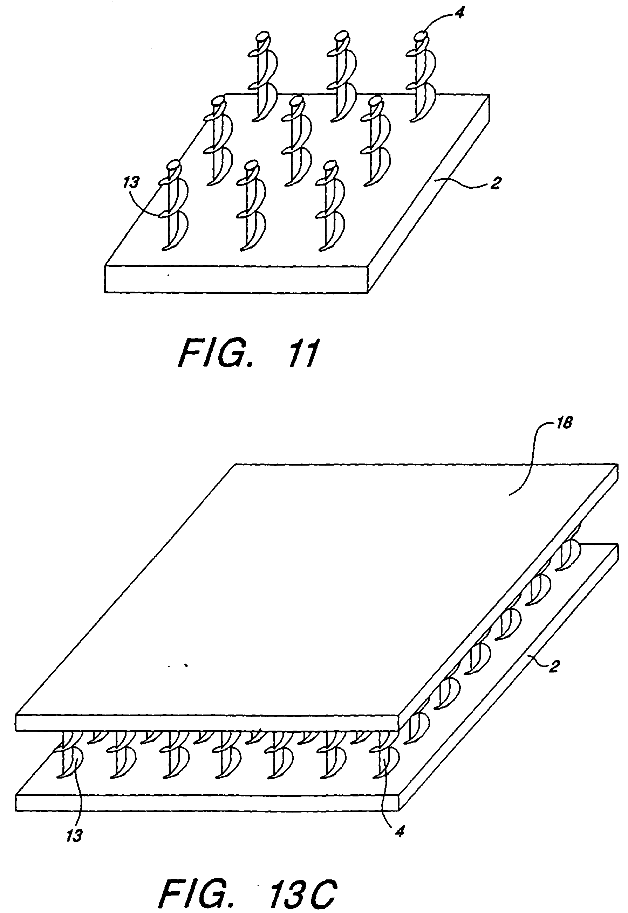

Referring to Figures 10A, and 10B, top and side views of a heat sink of the present invention are shown. The heat sink 1 has a rectangular base member 2 with a plurality of pin-fins 4 which protrude perpendicularly from the base member 2 and placed in in-line fashion. The pin-fins 4 are attached to the base member 2 to create a pattern wherein channels 16 are created between the rows of pins in transverse directions. A perspective view of a similar embodiment of the invention having spiral pin-fins is shown in Figure 11. These embodiments are preferred where it is desirable to move a large volume of heat exchanging fluid across the heat sink with little resistance. For example, as shown in the Figures 10A and 10B, heat exchanging fluid which flows along fluid flow lines 17 passes easily between the pin-fins through the channels 16. These embodiments are particularly applicable to large heat sinks where uniform heat dissipation is important across the entire surface of the heat sink.

The pin-fins 4 are either machined or molded and then bonded to the heat sink base member 2 by soldering the pin-fins 4 to the base member 2. The pin-fins 4 are constructed from a high thermal conductivity material, such as copper, aluminum or high thermal conductivity plastic, or any other material known to persons of skill.

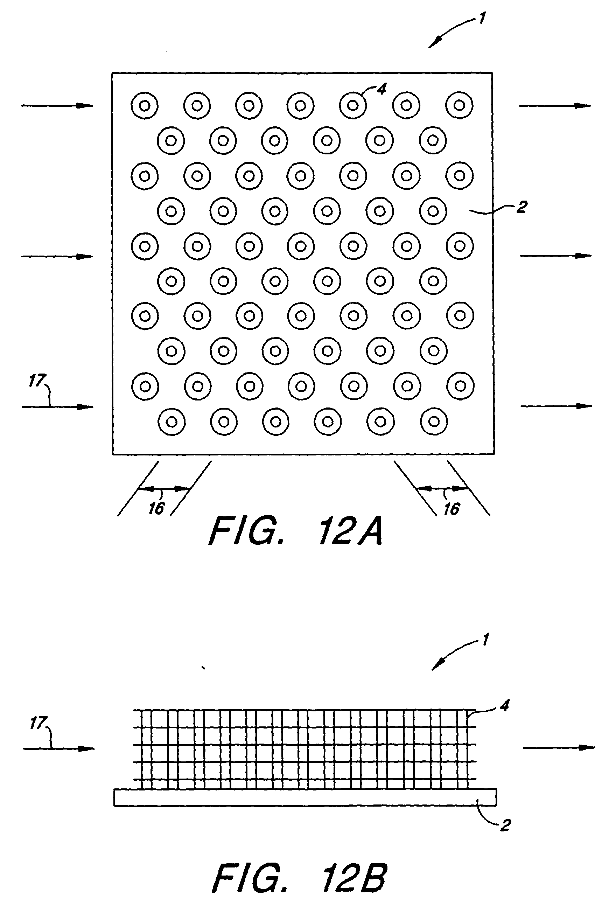

Referring to Figures 12A and 12B, top and side views of a heat sink of the present invention are shown. Pin-fins 4 are perpendicularly attached to base member 2 according to a particular pattern and placed in staggered fashion. The pin-fins 4 are more densely packed to create channels 16 which are neither perpendicular nor parallel to fluid flow lines 17. As heat exchanging fluid enters one side of the heat exchanger, the fluid passes from side to side as it flows around the pin-fins 4 until it reaches the opposite side of the heat sink 1. This pattern significantly increases the turbulence of the heat exchanging fluid. According to this and similar embodiments which have densely packed pin-fins 4 with planar disc fins, the heat sink is effectively a quasi-ducted heat sink. When the pins fins 4 are densely packed, the planar disc fins of one pin-fin are immediately adjacent the planar disc fins of the next pin-fin. Each level of planar disc fins, which are equidistant from the base member 2 of the heat sink 1, collectively form a ducting surface which forces heat exchanging fluid to remain close to the base member 2 as it passes over the heat sink.

A further embodiment of the heat sink has pin-fins 4 with spiral fins 13. Depending on the pattern in which the pin-fins 4 are attached to the base member of the heat sink, the spiral fins 13 wrap around the central pins 12 of each pin-fin 4 in clockwise or counterclockwise directions. The turbulence may be increased by alternating the direction of wrap of the spiral fins 13 for adjacent pin-fins 4.

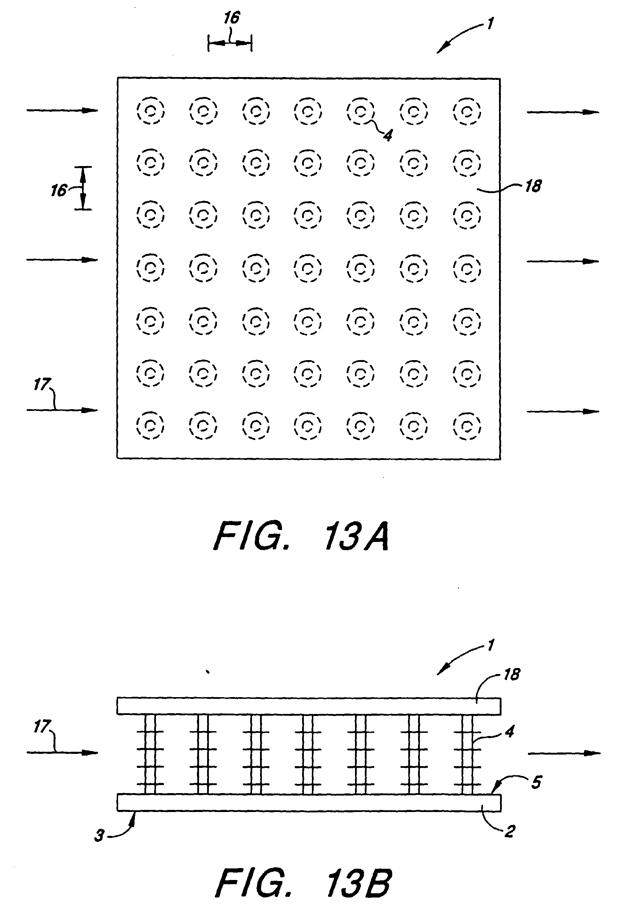

Figures 13A and 13B depict a heat sink 1 according to still a further embodiment of the invention. In this embodiment, the heat sink 1 is similar to the heat sink shown in Figures 10A and 10B and has a base member 2 having a lower base surface 3 and an upper-heat dissipating surface 5. Pin-fins 4 are attached perpendicularly to the upper heat dissipating surface 5 of the heat sink base 2. A top plate 18 is disposed on top of the pin-fins 4 in order to create a ducted heat sink which allows air flow through the space between the base member 2 and the top plate 18. In this version, the air, or other fluid, which flows through the heat sink 1 must go through the space between the base member 2 and the top plate 18 and cannot rise, or fall, perpendicularly from the heat sink base 2, as is the case in the heat sink shown in Figures 10A and 10B. This version of the invention is particularly useful if fluid flow by-pass is undesirable from the top surface of the heat sink. Of course, a top plate 18 may be used with most all embodiments of the invention.

Figure 13C shows a perspective view of a ducted heat sink similar to the embodiment shown in Figure 13A and 13B. Rather than disc fins, however, the pin-fins 4 have spiral fins 13.

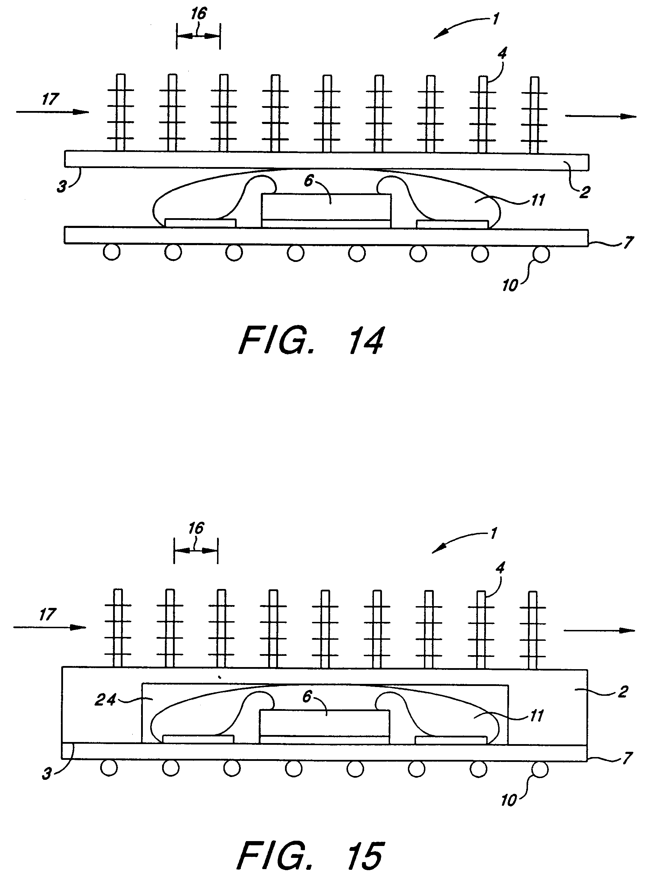

According to a further embodiment, the invention is adaptable especially to encapsulated, or "glob-top" packages, such as that shown in Figure 2. More specifically, Figure 14 is a cross-sectional view illustrating one difficulty of attaching a heat sink 1 to a glob top package. In this case, the base member 2 of the heat sink 1 rests upon the encapsulate 11 of the package. This creates a gap between the lower base surface 3 of the heat sink 1 and the package substrate 7. This gap makes correct fitting of the heat sink 1 to the semiconductor package difficult, and increases mechanical stresses on the package.

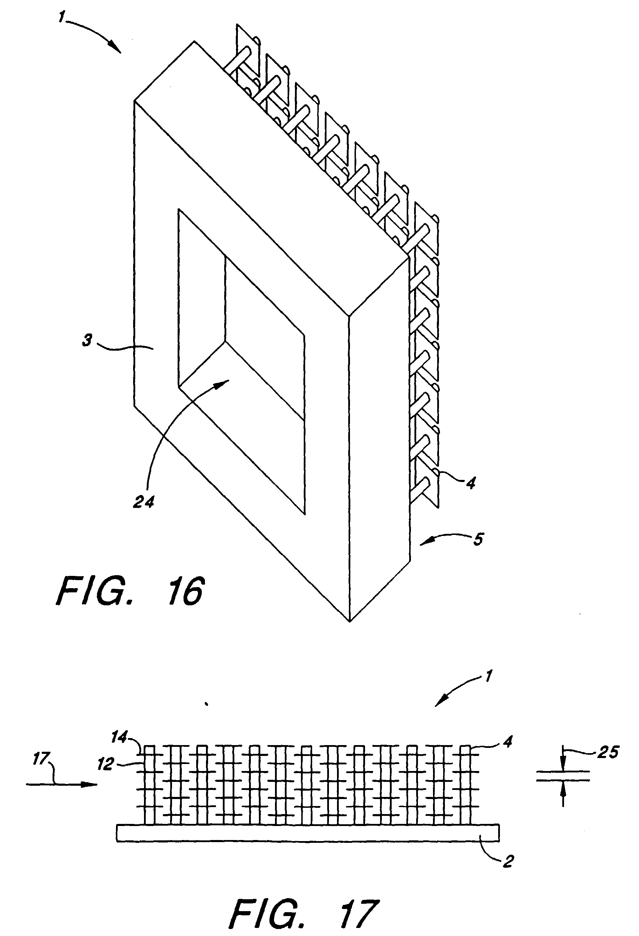

Figure 16 is a perspective view of an embodiment of the invention which overcomes the above problem. In this case, the heat sink 1 is provided with a plurality of pin-fins, as described above. The pin-fins 4 are attached to the upper surface 5 of the heat sink base member 2. A recess 24 is formed in the lower base surface 3 of the heat sink base member 2. The dimensions of the recess 24 are such that it receives the encapsulate 11 of the package substrate. This is illustrated in greater detail in Figure 15.

Figure 15 shows a cross-sectional view of the embodiment of the invention shown in Figure 16 as attached to a glob-top package. In this case, the recess 24 receives the encapsulate 11 formed on the package substrate 7. This permits the lower base surface 3 of the heat sink base member 2 to rest directly against the substrate 7. The heat sink 1 may be attached to the package substrate by conventional methods, such as mechanical clips, or adhesives.

Referring to Figure 17, a side view of a heat sink of the present invention is shown. The heat sink 1 is equipped with pin-fins 4 which are perpendicularly attached to a base member 2 of the heat sink 1. Each of the pin-fins 4 has several disc fins 14 attached to each central pin 12 of the pin-fins 4. The disc fins 14 of adjacent pin-fins 4 are offset 25 from each other to enable the pin-fins to be more densely packed on the heat sink. The disc fins 14 of one pin-fin 4 protrude between or overlap the disc fins 14 of the adjacent pin-fins 4 so that the central pins 12 of each of the pins-fins are spaced more closely to each other than possible without offset, overlapping disc fins. A similar embodiment of the invention comprises pin-fins with spiral fins wherein adjacent pin-fins have spiral fins which rotate upwardly in the same direction and have similar pitch. The adjacent spiral fins overlap.

Although the invention has been described with respect to the particular embodiments discussed above, it will be apparent to those of skill in the art that variations in form and detail may be made without departing from the scope and spirit of the present invention.

**Claims**

1. A heat sink (1) useful with semiconductor packages, the heat sink comprising a base member (2) having an upper surface (5) and a lower surface (3), the lower surface being attachable to a surface of a semiconductor package, and a plurality of heat dissipating pin-fins (4), wherein each pin-fin of said plurality comprises a bonding point (20) and a distal end, wherein each pin-fin of said plurality is coupled to the upper surface of the base member at the bonding point, the heat sink being characterized by:
   each pin-fin (4) of said plurality of heat dissipating pin-fins comprises a central pin (12) to which at least one fin is attached.

2. A heat sink as in Claim 1, wherein said at least one fin comprises a spiral fin (13).

3. A heat sink as in Claim 1, wherein said at least one fin comprises a disc fin (14).

4. A heat sink as in Claims 1, 2 or 3 wherein said at least one fin is warped.

5. A heat sink as in Claims 1, 2 or 3 wherein said at least one fin is corrugated.

6. A heat sink as in Claims 1-5, wherein said plurality of heat dissipating pin-fins are attached to said base member in linear rows with channels between.

7. A heat sink as in Claim 1, wherein said at least one fin is a planar disc fin, and wherein said plurality of heat dissipating pin-fins are attached to said base member in a densely packed pattern so that the planar disc fins collectively quasi-duct the heat sink.

8. A heat sink as in Claims 1-7, further comprising a top plate (18) attached to the distal ends of each pin-fin of said plurality of heat dissipating pin-fins.

9. A heat sink as in Claim 1-8, further comprising a recess (24) in the lower surface of said base member, wherein said recess is capable of receiving a protrusion of the semiconductor package.

10. A heat sink as in Claims 1-9, wherein the at least one fin of a first pin-fin of said plurality of heat dissipating pin-fins overlaps the at least one fin of a second pin-fin of said plurality of heat dissipating pin-fins.

*16*

*1*

○ ○ ○ ○ ○ ○ ○

*4*

○ ○ ○ ○ ○ ○ ○

*16*

*2*

○ ○ ○ ○ ○ ○ ○

○ ○ ○ ○ ○ ○ ○

○ ○ ○ ○ ○ ○ ○

○ ○ ○ ○ ○ ○ ○

*17*

○ ○ ○ ○ ○ ○ ○

*FIG. 1A*

*16*

*1*

*17*

*4*

*2*

*FIG. 1B*

*4a*

*4b*

*1*

*2*

# FIG. 1C

*4n*

*5*

*3*

*9*

*11*

*6*

*7*

*8*

*10*

# FIG. 2

FIG. 3A

FIG. 3B

*FIG. 4*

*FIG. 5*

10

FIG. 6

FIG. 7

FIG. 9

FIG. 8

FIG. 10A

FIG. 10B

FIG. 11

FIG. 13C

FIG. 12A

FIG. 12B

## FIG. 13A

## FIG. 13B

FIG. 14

FIG. 15

FIG. 16

FIG. 17